# EUROPÄISCHE PATENTSCHRIFT

(11) **EP 4 422 998 B1**
(45) Veröffentlichungstag und Bekanntmachung des Hinweises auf die Patenterteilung: **24.09.2025**
(21) Anmeldenummer: 22802121.8
(22) Anmeldetag: 17.10.2022
(51) Int. Cl.: B66B 31/02

(54) **TEMPERIER-VORRICHTUNG FÜR EINEN HANDLAUF EINER FAHRTREPPE ODER EINES FAHRSTEIGES**
TEMPERATURE CONTROL DEVICE FOR A HANDRAIL OF AN ESCALATOR OR A MOVING WALKWAY
DISPOSITIF DE THERMORÉGULATION POUR UNE MAIN COURANTE D'UN ESCALIER ROULANT OU D'UN TROTTOIR ROULANT

(30) Priorität: 26.10.2021 EP 21204664
(43) Veröffentlichungstag der Anmeldung: 04.09.2024
(73) Patentinhaber: INVENTIO AG, 6052 Hergiswil (CH)
(72) Erfinder: JIAO, Chen, Shanghai 201815 (CN)
(74) Vertreter: Inventio AG
(86) Internationale Anmeldenummer: PCT/EP2022/078757
(87) Internationale Veröffentlichungsnummer: WO 2023/072643

(56) Entgegenhaltungen:
- DE-A1- 102015 212 483
- JP-A- 2017 081 678
- JP-B1- 6 039 037

## Beschreibung

Die vorliegende Erfindung betrifft eine Handlauftemperier-Vorrichtung für einen Handlauf einer Fahrtreppe oder eines Fahrsteiges.

Fahrtreppen und Fahrsteige werden seit mehr als hundert Jahren als Förderanlagen für Personen in öffentlichen Räumen eingesetzt. Einsatzorte sind hierbei Kaufhäuser, Shoppingmalls, Flughäfen, Bahnhöfe, U-Bahnstationen, Freizeitparks und dergleichen mehr. Solche Förderanlagen werden mehrheitlich in klimatisierten, meist vor direkter Sonneneinstrahlung geschützten Innenräumen angeordnet und betrieben, so dass die klimatischen Umgebungsbedingungen auf den Fahrkomfort kaum Auswirkungen haben.

Fahrtreppen und Fahrsteige können auch vollständig im Aussenbereich oder teilweise aus Bauwerken herausragend, installiert werden. Die im Außenbereich eingesetzten Fahrtreppen und Fahrsteige weisen das Problem auf, dass sich deren Handläufe bei Sonneneinstrahlung erwärmen. Diese Erwärmung führt dazu, dass die Benutzung des Handlaufs als unangenehm empfunden wird. Personen unterlassen es daher oftmals, sich bei Nutzung einer Fahrtreppe oder Fahrsteigs an dem erwärmten Handlauf festzuhalten. Hierdurch erhöht sich die Gefahr von Stürzen.

**In** heißen und trockenen Ländern kann sich ein der direkten Sonneneinstrahlung ausgesetzter Handlauf auf Temperaturen von bis zu 75° Celsius aufheizen. Insbesondere besteht bei starker Aufheizung des Handlaufs das Risiko, dass Personen sich bei Kontakt mit dem derart aufgeheizten Handlauf Verbrennungen zuziehen.

Das Problem des Aufheizens von Handläufen von Fahrtreppen oder Fahrsteigen wird dadurch begünstigt, dass die Handläufe üblicherweise aus synthetischem Gummi oder verschiedenen Kunststoffmischungen bestehen. Die schwarze Farbe der Handläufe verstärkt den Effekt der Aufheizung. Gummi beziehungsweise Kunststoffe sind schlechte Wärmeleiter (Lambda ungefähr 0,16-0,27 W/m K). Daher lässt sich ein einmal aufgeheizter Handlauf nur langsam oder nur durch hohe Temperaturunterschiede wieder abkühlen.

Zudem wird beim Anlaufen von Fahrtreppen oder Fahrsteigen zusätzliche Energie durch den Antrieb und durch Reibungswärme an den Gleitführungsschienen in den Handlauf eingebracht.

Das Aufwärmen des Handlaufs wird weiter dadurch begünstigt, dass immer mehr Fahrtreppen vom Dauerbetrieb in eine intermittierende Betriebsart geschaltet werden, um Energie zu sparen. Dies bedeutet, dass die Fahrtreppe stillsteht, solange keine Person die Fahrtreppe benutzt. In dieser Zeit des Stillstandes ist der sogenannte Handlaufvorlauf der Sonne vollständig ausgesetzt. Der sogenannte Handlaufrücklauf ist dagegen im Inneren der Tragkonstruktion nur der Umgebungstemperatur ausgesetzt.

Um der Erwärmung des Handlaufs entgegenzuwirken, kann eine Kühlung für den Handlauf vorgesehen werden. Fahrtreppen mit einer Kühlvorrichtung zum Kühlen des Handlaufs sind im Stand der Technik bekannt.

So offenbart die Druckschrift JP 2007 238309 A eine Fahrtreppe mit einem Kühlsystem für den Handlauf, bei der mittels eines Klimagerätes ein kalter Luftstrom erzeugt wird. Über einen isolierten Kanal wird der gesamte rücklaufende Handlauf gekühlt. Das Kühlsystem ist dabei ein geschlossenes Kühlsystem. Sensoren regeln die Kühlung, sodass die Handlauftemperatur dauerhaft unter einem definierten Wert gehalten wird. Mittels einer solchen Anlage sind Lufttemperatur-Unterschiede von ca. 5 °C erzielbar. Der Unterschied der kühlenden Luft zu der Umgebungstemperatur ist verhältnismässig gering, so dass ein Abkühlen des Handlaufs relativ lange dauert. Die Bauform dieser Anlagen ist zudem groß und es wird ein hoher Geräuschpegel durch die Lüfter und das Gebläse erzeugt. Der Energieaufwand für die gesamte Kühlanlage ist ebenfalls hoch.

Des Weiteren ist auch aus der Druckschrift JP 2000 263655 A eine Fahrtreppe mit einem Kühlsystem zu Kühlung des Handlaufs bekannt. Hierbei wird Alkohol mittels Druckluft auf den Handlauf gesprüht. Lüfter hinter der Alkohol-Sprühanlage fördern dabei die Verdunstung des Alkohols, so dass Verdunstungskälte entsteht, mittels welcher der Handlauf gekühlt wird. Da Alkohol entzündlich ist, ist die Verwendung von Alkohol nicht unkritisch. Darüber hinaus ist eine vergleichsweise geringe Temperaturdifferenz zwischen dem auf den Handlauf aufgebrachten Kühlmittel und der Umgebungstemperatur erzielbar. Das Abkühlen eines Handlaufs dauert somit relativ lang. Zudem hat diese Lösung den Nachteil, dass kontinuierlich Verbrauchsmaterial (Alkohol) zur Verfügung gestellt werden muss. Die vorgeschlagene Lösung erhöht erheblich die Betriebskosten und den zeitlichen Wartungsaufwand. Die JP 2017 081678 A, JP 6 039037 B1 und die DE 10 2015 212483 A1 offenbaren weitere Kühlsysteme für Handläufe, wobei JP 2017 081678 A eine Handlauftemperier-Vorrichtung gemäß dem Oberbegriff des Anspruchs 1 offenbart.

Die Aufgabe der vorliegenden Erfindung ist daher, eine Handlauftemperier-Vorrichtung bereitzustellen, die nur geringste Betriebsgeräusche erzeugt, kein Verbrauchsmaterial erfordert und trotzdem eine ausreichende Temperierung des Handlaufes gewährleistet. Diese Aufgabe wird gelöst durch eine Handlauftemperier-Vorrichtung für einen bewegbar angeordneten Handlauf einer Fahrtreppe oder eines Fahrsteiges. Die Handlauftemperier-Vorrichtung umfasst insbesondere einen Sockel, eine Rollenanordnung, welche auf dem Sockel angeordnet ist und ein Halbleiterkühlelement. Das Halbleiterkühlelement ist in einer Aussparung zwischen dem Sockel und der Rollenanordnung angeordnet.

Halbleiterkühlelemente, auch Peltier-Elemente genannt, sind seit Jahrzehnten bekannt und werden in vielen Bereichen wie beispielsweise in Autokühlschränken, externen Kühleinrichtungen für Mobiltelefone, Kältekompressen und dergleichen mehr verwendet. Die Halbleiterkühlelemente können in geeigneter Ausgestaltung einen Temperaturunterschied von mehr als 60 Kelvin zur Umgebungstemperatur erzeugen. Durch die spezifische Anordnung des Halbleiterkühlelementes kühlt dieses einerseits die Rollenanordnung herunter und gibt andererseits seine Wärme an den Sockel ab. Durch die Rollenanordnung kann ein direkter Oberflächenkontakt zwischen der Handlauftemperier-Vorrichtung und der abzukühlenden Oberfläche eines Handlaufs ermöglicht werden, so dass dadurch ein hervorragender Wärmeübergang zwischen der Rollenanordnung und dem Handlauf bei kleinstmöglichem Reibungswiederstand und Verschleiss erreicht wird.

Wie am Ende der vorliegenden Beschreibung erklärt wird, kann die Handlauftemperier-Vorrichtung bei kalten Umgebungstemperaturen auch zum Beheizen des Handlaufes verwendet werden. Der besseren Übersicht wegen wird die Erfindung nachfolgend fast durchgehend als Kühlvorrichtung beschrieben. Dies bedeutet aber nicht, dass hinsichtlich des Schutzumfanges auf deren Verwendung als Heizeinrichtung verzichtet wird.

In einer Ausgestaltung der Handlauftemperier-Vorrichtung umfasst die Rollenanordnung einen Rollenrahmen und eine Vielzahl von Rollen, die im Rollenrahmen nebeneinander und bezüglich ihrer Drehachsen parallel zueinander angeordnet, drehbar gelagert sind. Durch diese Ausgestaltung können die Rollen im Rollenrahmen zueinander präzise und damit mit geringstem Abstand zueinander gelagert werden, so dass gewissermassen durch die Rollen eine Fläche entsteht, über die der Handlauf geführt werden soll. Dessen Bewegungsrichtung ist orthogonal zu den Drehachsen der Rollen vorgesehen. Die durch die Rollen gebildete Fläche kann bezüglich der vorgesehenen Durchlaufrichtung des Handlaufes auch gegen den Handlauf hin konvex gewölbt sein, damit zwischen den Rollen und dem darüber geführten Handlauf eine ausreichende Anpresskraft erreicht werden kann.

In einer weiteren Ausgestaltung der Handlauftemperier-Vorrichtung umrahmt der Rollenrahmen die Rollen nur seitlich, wobei Zylinderflächen der Rollen zumindest eine Seitenfläche des Rollenrahmens überragen. Diese Seitenfläche umläuft gewissermassen alle Rollen. Die überragenden Bereiche der Zylinderflächen und die Seitenfläche sind dazu vorgesehen, gegen einen Handlauf gerichtet, in einer Fahrtreppe oder in einem Fahrsteig montiert zu werden. Hierdurch wird sichergestellt, dass der über die Rollen zu führende Handlauf nicht am stationär in der Fahrtreppe oder im Fahrsteig angeordneten Rollenrahmen streift und dadurch Material vom Handlauf abgetragen wird.

In einer weiteren Ausgestaltung der Handlauftemperier-Vorrichtung ist der Sockel aus einem wärmeleitenden Material hergestellt und weist ein Stützteil und eine Wärmeableitungsstruktur auf. Die Wärmeableitungsstruktur ist vorzugsweise auf einer dem Rollenrahmen abgewandten Seite des Stützteils angeordnet, so dass die abzugebende Wärme möglichst weit weg vom Handlauf an die Umgebungsluft abgegeben wird. Die Wärmeableitungsstruktur kann eine Anordnung von Kühlrippen oder Kühlstiften sein, welche die Oberfläche des Stützteils und somit die Wärmeabstrahlungsfläche vergrössern. Die Wärmeableitungsstruktur kann aber auch andere Ausprägungen aufweisen und beispielsweise als Luft- oder Wasser-Wärmetauscher konzipiert sein. Die Wärmeableitungsstruktur kann auch ein Wärmerohr (Heat-pipe) sein, mittels welchem die von der erwärmten Seite des in Betrieb stehenden Halbleiterkühlelements abzuführende Wärme beziehungsweise Abwärme auch ausserhalb einer Verschalung einer Fahrtreppe oder eines Fahrsteiges geführt werden und an die Umgebungsluft abgegeben werden kann.

In einer weiteren Ausgestaltung der Handlauftemperier-Vorrichtung kann das Stützteil eine Stützfläche und mindestens einen Vorsprung aufweisen, wobei der Vorsprung in Seitenbereichen des Stützteils auf der Stützfläche angeordnet ist. Der mindestens eine Vorsprung dient der Befestigung des Rollenrahmens in vorgegebenem Abstand zur Stützfläche und ragt deshalb in einer der Wärmeableitungsstruktur abgewandten Richtung von der Stützfläche auf. Durch dessen Anordnung im Randbereich bildet er eine Aussparung im Sockel und begrenzt diese zumindest teilweise. Hierbei ist die Aussparung in ihren Abmessungen derart ausgestaltet, dass darin mindestens ein Halbleiterkühlelement angeordnet werden kann. Da die Wärme an den Sockel abgegeben wird und dieser damit heiss wird, wird vorzugsweise zwischen dem mindestens einen Vorsprung und dem Rollenrahmen eine wärmeisolierende Schicht vorgesehen. Selbstverständlich kann der Rollenrahmen selbst aus einem wärmeisolierenden Material gefertigt sein.

In einer weiteren Ausgestaltung der Handlauftemperier-Vorrichtung können mindestens zwei Halbleiterkühlelemente in der Aussparung angeordnet sein, da diese als Massenware gefertigt, üblicherweise eine Dicke von 3mm bis 10mm und eine quadratische Grundfläche mit einer Kantenlänge von 20mm bis 90mm aufweisen.

Der Wärmeaustausch zwischen der kalten Seite des in Betrieb stehenden Halbleiterkühlelements und den Rollen erfolgt primär über Wärmestrahlung. Um einen möglichst guten Wärmetransport zu gewährleisten, werden die Zylinderoberflächen der Rollen möglichst nahe am Halbleiterkühlelement angeordnet. Da das Halbleiterkühlelement eine plattenartige Struktur aufweist, sind der Rollenrahmen, die Durchmesser der Rollen und der mindestens ein Vorsprung vorzugsweise derart aufeinander abgestimmt, dass die Zylinderflächen der Rollen einen minimalen Abstand von 0.0001mm bis 0.5mm, bevorzugt von 0.001mm bis 0.2mm, oder besonders bevorzugt von 0.01mm bis 0.1mm von der Kühlfläche des in der Aussparung angeordneten Halbleiterkühlelementes aufweisen. Bei der Auslegung des minimalen Abstandes müssen auch die Fertigungstoleranzen und Ebenheiten der Bauteile berücksichtigt werden, damit die Rollen nicht an der Kühlfläche streifen und trotzdem die Fertigungskosten tief gehaltenwerden können.

Damit möglichst viel Wärme vom Handlauf an das Halbleiterkühlelement übertragen werden kann, müssen die Rollen gute Wärmeleiteigenschaften aufweisen. Vorzugsweise werden die Rollen daher aus hauptsächlich Kupfer, aus einer Kupferlegierung, aus Aluminium oder aus einer Aluminiumlegierung gefertigt.

Da die Wärmeübertragung von den Rollen an die Kühlseite hauptsächlich über die Wärmestrahlung erfolgt, können die Rollen zumindest auf ihrer Zylinderfläche eine schwarze Beschichtung aufweisen.

Wie bereits weiter oben erwähnt, sind die vorangehend beschriebenen Varianten der Handlauftemperier-Vorrichtung zur Kühlung von Handläufen einer Fahrtreppe oder eines Fahrsteiges vorgesehen. Fahrtreppen oder Fahrsteige weisen mindestens eine Balustrade mit einem an der Balustrade umlaufend angeordneten Handlauf auf. Erfindungsgemäss wird für mindestens einen der vorhandenen Handläufe zum Kühlen von dessen Grifffläche mindestens eine Handlauftemperier-Vorrichtung mit ihrer Rollenanordnung unter dem Handlauf angeordnet. Hierbei wird die Grifffläche des Handlaufes über die Rollenanordnung geführt und steht mit dieser in Berührungskontakt.

In einer Ausgestaltung der Fahrtreppe oder des Fahrsteiges kann entlang einer Bewegungsrichtung des umlaufenden Handlaufes die mindestens eine Handlauftemperier-Vorrichtung relativ zu einem Startpunkt des den Handlaufgurt berührenden Fahrgastes stromaufwärts angeordnet sein. Mit anderen Worten wird die Handlauftemperier-Vorrichtung so platziert, dass sie nicht allzu weit von dem Punkt entfernt ist, an dem ein Fahrgast den Handlauf ergreift. Vorzugsweise wird in der Montageanweisung zum Montieren der Handlauftemperier-Vorrichtung vorgeschrieben, dass der Abstand zwischen der Handlauftemperier-Vorrichtung und dem Startpunkt entlang der Bewegungsrichtung des Handlaufgurts innerhalb eines bestimmten Bereichs liegen muss, so dass der Handlauf für den Benutzer nicht bereits wieder zu warm wirkt.

In einer weiteren Ausgestaltung der Fahrtreppe oder des Fahrsteiges können pro vorhandenen Handlauf wenigstens zwei Handlauftemperier-Vorrichtungen vorgesehen sein, die in Abständen entlang der Bewegungsrichtung des Handlaufes angeordnet sind.

Durch diese serielle Anordnung kann der Handlauf dem vorherrschenden Klima entsprechend, energieeffizient heruntergekühlt werden, indem beispielsweise bei geringerer Sonneneinstrahlung nur eine der beiden Handlauftemperier-Vorrichtungen betrieben wird.

In einer weiteren Ausgestaltung der Fahrtreppe oder des Fahrsteiges umfasst die Handlauftemperier-Vorrichtung eine Stromversorgung, welche dazu vorgesehen ist, dem Halbleiterkühlelement Strom zuzuführen. Zudem weist die Handlauftemperier-Vorrichtung ein Temperaturregelungsmodul auf, um die dem Halbleiterkühlelement zuzuführende Ausgangsleistung der Stromversorgung zu regeln. Mit anderen Worten ausgedrückt, regelt das Temperaturregelungsmodul die Ausgangsleistung der Stromversorgung beziehungsweise die dem Halbleiterkühlelement über die Zeit zuzuführende elektrische Energie.

In einer weiteren Ausgestaltung der Fahrtreppe oder des Fahrsteiges umfasst das Temperaturregelungsmodul einen Handlauf- Temperaturmesssensor und einen Prozessor. Der Handlauf- Temperaturmesssensor wird hierbei zum Messen der Temperatur des Handlaufs verwendet. Sinnvollerweise wird die Temperatur an einer Stelle des Handlaufs gemessen, die zwischen der Handlauftemperier-Vorrichtung und dem weiter oben beschriebenen Startpunkt angeordnet ist, so dass die Temperatur der heruntergekühlten Grifffläche erfasst werden kann. Der Prozessor verarbeitet die vom Handlauf-Temperaturmesssensor an ihn übertragene Messignale und ist dazu konfiguriert, die an das Halbleiterkühlelement übertragene Ausgangsleistung der Stromversorgung in Abhängigkeit von der vom Handlauf- Temperaturmesssensor gemessenen Temperatur des Handlaufs zu regeln. Hierdurch kann die Temperatur des Handlaufes derart geregelt werden, dass für den Fahrgast eine angenehme Haptik entsteht.

Die Haptik des Handlaufes ist auch von der Umgebungstemperatur der Fahrtreppe oder des Fahrsteiges abhängig. Wenn nämlich der Handlauf gegenüber der Umgebungstemperatur zu stark heruntergekühlt wird, empfindet der Fahrgast ihn als zu kalt und hält sich ebenfalls nicht am Handlauf fest. Zudem wird durch ein zu starkes Herunterkühlen sehr viel elektrische Energie verbraucht, ohne den beabsichtigten Nutzen zu erzielen. Um diese Situation zu vermeiden, kann das Temperaturregelungsmodul einen Umgebungs-Temperaturmesssensor umfassen, wobei der Umgebungs-Temperaturmesssensor zum Messen der Umgebungstemperatur der Fahrtreppe oder des Fahrsteiges verwendet wird. Der Prozessor ist hierbei dazu konfiguriert, die an das Halbleiterkühlelement übertragene Ausgangsleistung der Stromversorgung in Abhängigkeit von einer vorgegebenen Differenz zur Aussentemperatur und unter Berücksichtigung der vom Handlauf- Temperaturmesssensor gemessenen Temperatur des Handlaufs zu regeln.

Nachfolgend werden Ausführungsformen der Erfindung unter Bezugnahme auf die beigefügten Zeichnungen beschrieben, wobei weder die Zeichnungen noch die Beschreibung als die Erfindung einschränkend, auszulegen sind. Ferner werden für gleiche oder gleichartig wirkende Elemente dieselben Bezugszeichen verwendet. Es zeigen:
- Figur 1:: in einer Seitenansicht eine Handlauftemperier-Vorrichtung;
- Figur 2:: einen Querschnitt entlang der Linie A-A durch die Handlauftemperier-Vorrichtung der Figur 1;
- Figur 3:: in einer Draufsicht die in den Figuren 1 und 2 dargestellte Handlauftemperier-Vorrichtung;
- Figur 4:: eine dreidimensionale Ansicht eines Halbleiterkühlelementes, welches Teil der in den Figuren 1 bis 3 dargestellten Handlauftemperier-Vorrichtung ist;
- Figur 5:: eine dreidimensionale Ansicht einer Rollenanordnung, welche Teil der in den Figuren 1 bis 3 dargestellten Handlauftemperier-Vorrichtung ist;
- Figur 6:: eine dreidimensionale Ansicht eines Sockels, welcher Teil der in den Figuren 1 bis 3 dargestellten Handlauftemperier-Vorrichtung ist;
- Figur 7:: eine dreidimensionale Ansicht einer möglichen Anordnung der in den Figuren 1 bis 3 dargestellten Handlauftemperier-Vorrichtung in einer nur teilweise dargestellten Fahrtreppe.

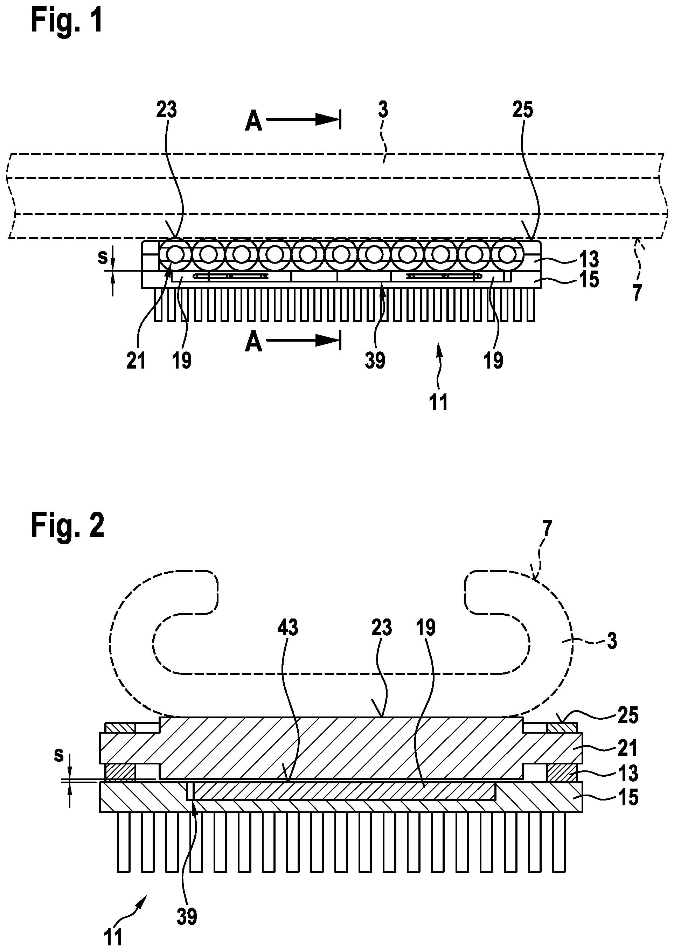

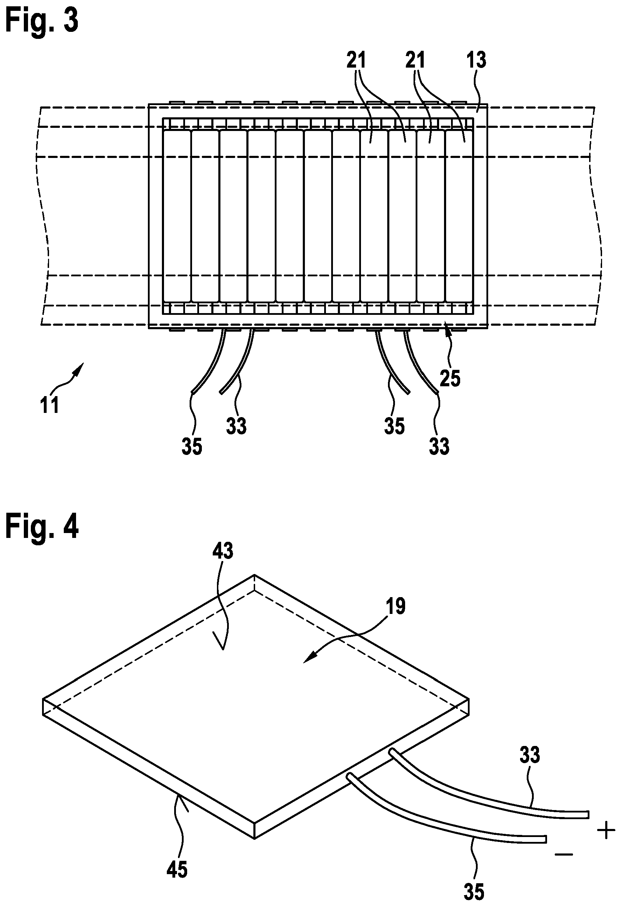

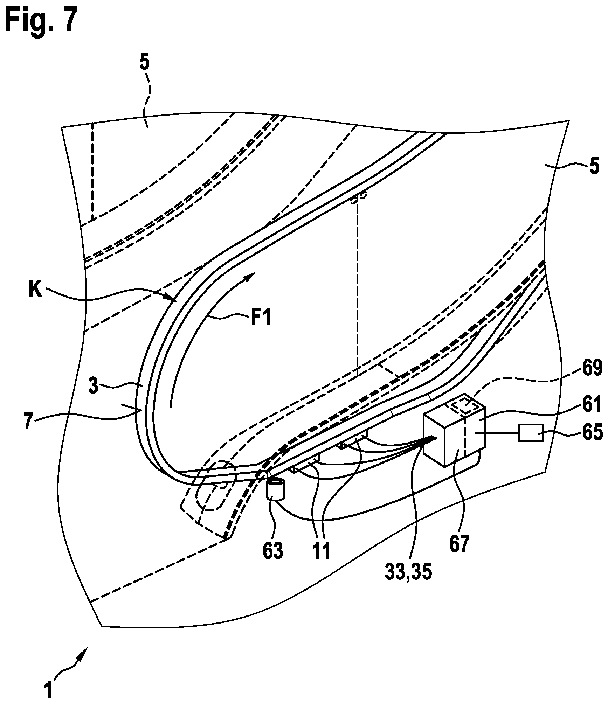

Die Figur 1 zeigt in einer Seitenansicht eine Handlauftemperier-Vorrichtung 11, welche in einer Fahrtreppe (siehe Figur 7) oder in einen Fahrsteig eingebaut werden kann, um deren bewegbaren Handläufe 3 (schematisch mit unterbrochener Linie dargestellt) zu kühlen. Die Figur 2 zeigt einen Querschnitt entlang der Linie A-A durch die Handlauftemperier-Vorrichtung 11 der Figur 1 und die Figur 3 eine Draufsicht der in den Figuren 1 und 2 dargestellten Handlauftemperier-Vorrichtung 11. Nachfolgend werden diese drei Figuren gemeinsam beschrieben.

Die Handlauftemperier-Vorrichtung 11 umfasst einen Sockel 15, der als Basis für weitere Bauteile dient. Diese weiteren Bauteile sind insbesondere eine Rollenanordnung 13, welche auf dem Sockel 15 angeordnet ist und mindestens ein Halbleiterkühlelement 19. Im vorliegenden Ausführungsbeispiel sind zwei Halbleiterkühlelemente 19 vorhanden, die zwischen dem Sockel 15 und der Rollenanordnung 13 in einer Aussparung 39 des Sockels 15 angeordnet sind. Die Ausgestaltung des Sockels 15, der Rollenanordnung 13 und des Halbleiterkühlelementes 19 wird weiter unten anhand der Figuren 4 bis 6 beschrieben.

Wie aus den Figuren 1 bis 3 ersichtlich ist, weist der Rollenrahmen 13 eine Vielzahl von Rollen 21 auf, die mit sehr wenig Abstand S oberhalb der Halbleiterkühlelemente 19 angeordnet sind, so dass ein möglichst guter Wärmeaustausch zwischen den Rollen 21 des Rollenrahmens 15 und den Halbleiterkühlelementen 19 gewährleistet wird. Um dies zu erreichen, sind die Durchmesser der Rollen 21 und die Ausgestaltung des Sockels 15 derart aufeinander abgestimmt, dass Zylinderflächen 23 der Rollen 21 einen minimalen Abstand S von 0.0001mm bis 0.5mm, bevorzugt von 0.001mm bis 0.2mm, besonders bevorzugt von 0.01mm bis 0.1mm von einer Kühlfläche 43 (siehe auch Figur 4) des in der Aussparung 39 angeordneten Halbleiterkühlelementes 19 aufweisen.

Die Figur 4 zeigt eine dreidimensionale Ansicht eines Halbleiterkühlelementes 19 der in den Figuren 1 bis 3 dargestellten Handlauftemperier-Vorrichtung 11. Halbleiterkühlelemente 19, auch Peltier-Elemente genannt, sind seit Jahrzehnten bekannt und werden in vielen Bereichen wie beispielsweise in Autokühlschränken, externen Kühleinrichtungen für Mobiltelefone, Kältekompressen und dergleichen mehr verwendet.

Grundlage für den Peltier-Effekt ist der Kontakt von zwei Halbleitern, die ein unterschiedliches Energieniveau (entweder p- oder n-leitend) der Leitungsbänder besitzen. Leitet man einen Strom durch zwei hintereinanderliegende Kontaktstellen dieser Materialien, so muss an der einen Kontaktstelle Wärmeenergie aufgenommen werden, damit das Elektron in das energetisch höhere Leitungsband des benachbarten Halbleitermaterials gelangt, folglich kommt es zur Abkühlung. An der anderen Kontaktstelle fällt das Elektron von einem höheren auf ein tieferes Energieniveau, so dass hier Energie in Form von Wärme abgegeben wird.

Da n-dotierte Halbleiter ein niedrigeres Energieniveau des Leitungsbandes aufweisen, erfolgt die Kühlung dabei an der Stelle, an der Elektronen vom n-dotierten in den p-dotierten Halbleiter übergehen (technischer Stromfluss also vom p-dotierten zum n-dotierten Halbleiter).

Ein Peltier-Element besteht aus zwei oder mehreren kleinen Quadern je aus p- und n-dotiertem Halbleitermaterial (Bismuttellurid, Siliciumgermanium), die abwechselnd oben und unten durch Metallbrücken miteinander verbunden sind (nicht im Detail dargestellt). Die Metallbrücken bilden zugleich die thermischen Kontaktflächen und sind durch eine aufliegende Folie oder eine Keramikplatte isoliert. Immer zwei unterschiedliche Quader sind so miteinander verbunden, dass sie eine Reihenschaltung ergeben. Der zugeführte elektrische Strom durchfließt alle Quader nacheinander. Abhängig von Stromstärke und - richtung kühlen sich die Verbindungsstellen der ersten Seite ab, während sich die Verbindungsstellen der anderen Seite erwärmen. Der Strom pumpt somit Wärme von einer Kühlfläche 43 auf eine Heizfläche 45 und erzeugt eine Temperaturdifferenz zwischen diesen Keramikplatten.

Die gebräuchlichste Form von Peltier-Elementen besteht aus zwei meist quadratischen Platten aus Aluminiumoxid-Keramik mit einer Kantenlänge von 20 mm bis 90 mm und einem Abstand von 3 mm bis 5 mm, zwischen denen die Halbleiter-Quader eingelötet sind. Die Keramikflächen sind hierzu an ihren zugewandten Flächen mit lötbaren Metallflächen versehen. Das Halbleiterkühlelement 19 weist somit eine plattenartige Struktur auf.

Ohne weitere Maßnahmen kann die Wärmedifferenz zwischen der Kühlfläche 43 bzw. der Heizfläche 45 des Halbleiterkühlelementes 19 und der Umgebung (z. B. Luft) hauptsächlich nur über Wärmestrahlung ausgeglichen werden, viel weniger durch Konvektion. Die zwischen der Kühlfläche 43 und der Heizfläche 45 transportierte Wärmemenge bleibt aber gleich, und somit auch die Temperaturdifferenz. Die Temperaturdifferenz zwischen Kühlfläche 43 und Heizfläche 45 kann, je nach Elementaufbau und zugeführtem Strom, bei einstufigen Halbleiterkühlelementen 19 bis ca. 70 Kelvin betragen.

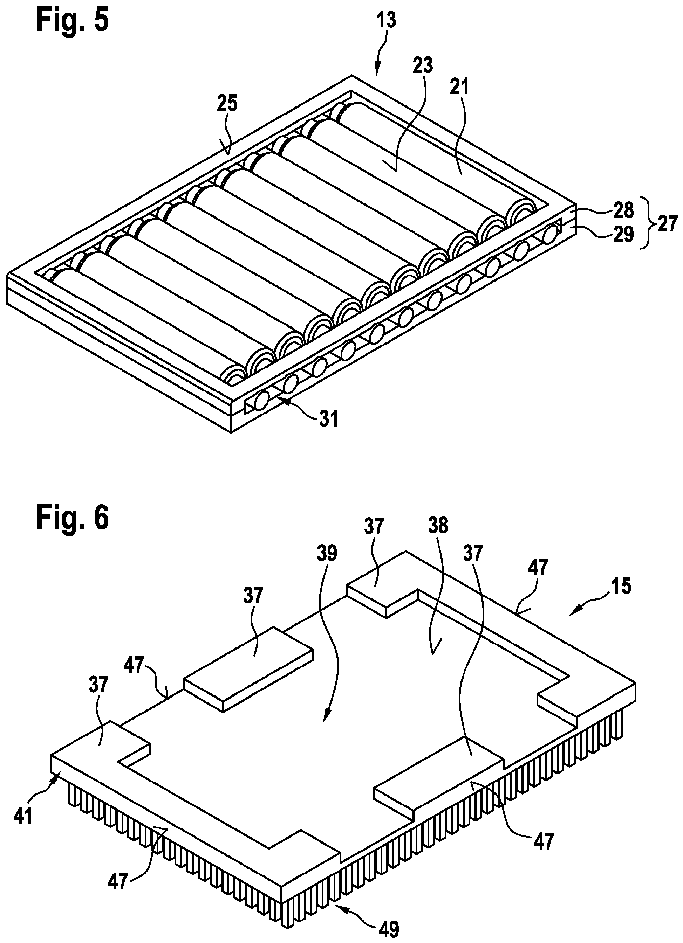

Die Figur 5 zeigt eine dreidimensionale Ansicht einer Rollenanordnung 13 der in den Figuren 1 bis 3 dargestellten Handlauftemperier-Vorrichtung 11. Die Rollenanordnung 13 umfasst einen Rollenrahmen 27 und eine Vielzahl von Rollen 21, die im Rollenrahmen 27 angeordnet und drehbar gelagert sind. Um möglichst wenig Reibungsverluste und damit minimale Verschleisserscheinungen am darüber zu führenden Handlauf 3 (siehe Figur 1) zu erreichen, sind die Rollen 21 nebeneinander und bezüglich ihrer Drehachsen parallel zueinander angeordnet.

Der Rollenrahmen 27 weist zwecks einfacher Montage der Rollen 21 ein Oberteil 28 und ein Unterteil 29 auf, wobei als Lagerstellen 31 der Rollen 21 im Oberteil 28 und Unterteil 29 entsprechende Lagerschalen ausgebildet sind. Vorzugsweise ist der Rollenrahmen 27 aus einem Material gefertigt, welches gute Gleitlagereigenschaften und geringe Wärmeleiteigenschaften aufweist. Der Rollenrahmen 27 kann beispielsweise aus einem Polymerwerkstoff oder faserverstärkten Polymerwerkstoff gefertigt sein. Selbstverständlich kann der Rollenrahmen 27 auch aus einem Metall, beispielsweise aus Stahl gefertigt sein.

Der Rollenrahmen 27 umrahmt die Rollen 21 nur seitlich, wobei Zylinderflächen 23 der Rollen 21 zumindest eine Seitenfläche 25 des Rollenrahmens 27; hier des Oberteils 28, überragen. Diese Seitenfläche 25 umläuft gewissermassen alle Rollen 21 und ist dazu vorgesehen, gegen einen Handlauf 3 gerichtet, in einer Fahrtreppe 1 (siehe Figuren 1 und 7) oder in einem Fahrsteig montiert zu werden. Hierdurch wird sichergestellt, dass der über die Rollen zu führende Handlauf 3 nicht am stationär in der Fahrtreppe 1 oder im Fahrsteig angeordneten Rollenrahmen 27 streift und dadurch Material vom Handlauf 3 abgetragen wird.

Um möglichst viel Wärme vom Handlauf 3 an das Halbleiterkühlelement 19 übertragen zu können, sollten die Rollen 21 gute Wärmeleiteigenschaften aufweisen. Vorzugsweise werden die Rollen hauptsächlich aus Kupfer, aus einer Kupferlegierung, aus Aluminium oder aus einer Aluminiumlegierung gefertigt.

Da der Wärmeübergang von den Rollen 21 an die Kühlseite 43 hauptsächlich über Wärmestrahlung erfolgt, können die Rollen 21 zumindest auf ihrer Zylinderfläche 23 eine schwarze Beschichtung aufweisen.

Die Figur 6 zeigt eine dreidimensionale Ansicht eines Sockels 15 der in den Figuren 1 bis 3 dargestellten Handlauftemperier-Vorrichtung 11. Der Sockel 15 ist aus einem wärmeleitenden Material gefertigt und weist ein Stützteil 41 und eine Wärmeableitungsstruktur 49 auf. Das Stützteil 41 umfasst eine Stützfläche 38 und vier Vorsprünge 37. Die Vorsprünge 37 sind in Seitenbereichen 47 des Stützteils 41 auf der Stützfläche 38 angeordnet und ragen in einer der Wärmeableitungsstruktur 49 abgewandten Richtung von der Stützfläche 38 auf. Durch die Vorsprünge 37 wird die Aussparung 39 im Stützteil 41 geschaffen, wobei die Aussparung 39 in ihren Abmessungen derart ausgestaltet ist, dass darin mindestens ein Halbleiterkühlelement 19 angeordnet werden kann. Im vorliegenden Ausführungsbeispiel ist die Aussparung 39 so gross bemessen, dass zwei der in Figur 4 dargestellten Halbleiterkühlelemente 19 darin angeordnet werden können.

Wie in den Figuren 1 bis 3 dargestellt, wird auf den Vorsprüngen 37 die Rollenanordnung 13 befestigt. Die Wärmeableitungsstruktur 49 ist somit auf einer den Vorsprüngen 37 und damit dem Rollenrahmen 27 der Rollenanordnung 13 abgewandten Seite des Stützteils 41 angeordnet.

Die Figur 7 zeigt eine dreidimensionale Ansicht einer nur teilweise dargestellten Fahrtreppe 1, sowie eine mögliche Anordnung der in den Figuren 1 bis 3 dargestellten Handlauftemperier-Vorrichtung 11 in dieser Fahrtreppe 1.

Fahrtreppen 1 weisen üblicherweise zwei Balustraden 5 auf, an denen jeweils ein umlaufend bewegbarer Handlauf 3 angeordnet ist. Zum Temperieren einer Grifffläche 7 des Handlaufes 3 wird mindestens eine Handlauftemperier-Vorrichtung 11 mit ihrer Rollenanordnung 13 (siehe Figuren 1 bis 6) unter dem Handlauf 3 angeordnet. Hierbei wird die Grifffläche 7 des Handlaufes 3 über die Rollen 21 der Rollenanordnung 13 geführt und steht mit diesen in Berührungskontakt.

Wie im vorliegenden Ausführungsbeispiel dargestellt, sind für jeden Handlauf 3 zwei hintereinander angeordnete Handlauftemperier-Vorrichtungen 11 vorgesehen. Diese werden relativ zu einem Startpunkt K des Handlaufs 3 stromaufwärts entlang einer Bewegungsrichtung F1 des umlaufenden Handlaufes 3 angeordnet. Der Startpunkt K ist hierbei die ungefähre Stelle am Handlauf 3, die ein Fahrgast beim Betreten der Fahrtreppe 1 zuerst mit seiner Hand berührt. Mit anderen Worten werden die Handlauftemperier-Vorrichtungen 11 so platziert, dass sie nicht allzu weit von dem Startpunkt K entfernt sind, an dem ein Fahrgast den Handlauf 3 ergreift. Vorzugsweise wird in der Montageanweisung zum Montieren der Handlauftemperier-Vorrichtung 11 vorgeschrieben, dass der Abstand zwischen der Handlauftemperier-Vorrichtung 11 und dem Startpunkt K entlang der Bewegungsrichtung F1 des Handlaufs 3 innerhalb eines bestimmten Bereichs liegt.

Die Handlauftemperier-Vorrichtung 11 umfasst zudem eine Stromversorgung 67, um dem Halbleiterkühlelement 11 je nach Bedarf Strom zuzuführen. Genaugenommen wird über die Stromleitungen 33, 35 ein Gleichstrom zugeführt, wobei auf die korrekte Polarität geachtet werden muss. Des Weiteren weist die Handlauftemperier-Vorrichtung 11 ein Temperaturregelungsmodul 61 auf, um die dem Halbleiterkühlelement 11 zuzuführende Ausgangsleistung der Stromversorgung 67 zu regeln.

Das Temperaturregelungsmodul 61 umfasst hierzu einen Handlauf-Temperaturmesssensor 63 und einen Prozessor 69 mit einer geeigneten Verarbeitungssoftware. Der Handlauf-Temperaturmesssensor 63 wird zum Messen der Temperatur des Handlaufs 3 verwendet und überträgt kontinuierlich oder periodisch seine Messsignale an den Prozessor 69. Sinnvollerweise wird die Temperatur an einer Stelle des Handlaufs 3 gemessen, die zwischen der Handlauftemperier-Vorrichtung 11 und dem weiter oben beschriebenen Startpunkt K angeordnet ist, so dass die Temperatur der heruntergekühlten Grifffläche 7 erfasst werden kann. Der Prozessor 69 verarbeitet die vom Handlauf-Temperaturmesssensor 63 an ihn übertragene Messignale und ist dazu konfiguriert, die an das Halbleiterkühlelement 19 übertragene Ausgangsleistung der Stromversorgung 67 in Abhängigkeit der vom Handlauf-Temperaturmesssensor 63 gemessenen Temperatur des Handlaufs 3 zu regeln. Hierdurch kann die Temperatur des Handlaufes 3 derart geregelt werden, dass für den Fahrgast eine angenehme Haptik entsteht.

Um Eine angenehme Haptik des Handlaufes 3 auch bezüglich der Umgebungstemperatur der Fahrtreppe 1 zu schaffen, weist das Temperaturregelungsmodul 61 einen Umgebungs-Temperaturmesssensor 65 auf, wobei der Umgebungs-Temperaturmesssensor 65 zum Messen der Umgebungstemperatur der Fahrtreppe 1 oder des Fahrsteiges verwendet wird. Der Prozessor 69 ist ferner dazu konfiguriert, die an das Halbleiterkühlelement 11 übertragene Ausgangsleistung der Stromversorgung 67 in Abhängigkeit von einer vorgegebenen Differenz zur Aussentemperatur und unter Berücksichtigung der vom Handlauf-Temperaturmesssensor 63 gemessenen Temperatur des Handlaufs 3 zu regeln.

Obwohl die Figuren 1 bis 7 unterschiedliche Aspekte der vorliegenden Erfindung anhand einer als Fahrtreppe 1 ausgestalteten Personentransportanlage zeigen, ist es offensichtlich, dass die beschriebene Handlauftemperier-Vorrichtung 11 gleichermaßen auch bei schräg angeordneten Fahrsteigen oder horizontal angeordneten Fahrsteigen verwendet werden kann. Wie bereits weiter oben erklärt wurde, weisen Halbleiterkühlelemente 19 eine Kühlfläche 43 und eine Heizfläche 45 auf. Deren Eigenschaft, Heizfläche 45 oder Kühlfläche 43 zu sein, hängt von der Polarität des zugeführten Gleichstromes über die Stromleitungen 33, 35 ab. Es ist daher offensichtlich, dass die vorliegende Handlauftemperier-Vorrichtung 11 bei einer Umpolung mittels des Temperaturregelungsmoduls 61 nicht nur als Handlaufkühlvorrichtung, sondern auch als Handlaufheizvorrichtung verwendet werden kann, ohne die vorliegende Konstruktion zu ändern. Gegebenenfalls müsste lediglich der Rollenrahmen 27 der Rollenanordnung 13 aus einem temperaturbeständigen Material gefertigt sein.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Handlauftemperier-Vorrichtung (11) für einen bewegbar angeordneten Handlauf (3) einer Fahrtreppe (1) oder eines Fahrsteiges, wobei die Handlauftemperier-Vorrichtung (11) umfasst:
• einen Sockel (15); und
ein Halbleiterkühlelement (19),
**dadurch gekennzeichnet, dass** die Handlauftemperier-Vorrichtung (11) weiter
• eine Rollenanordnung (13) umfasst, welche auf dem Sockel (15) angeordnet ist; und
• dass das Halbleiterkühlelement (19) in einer Aussparung (39) zwischen dem Sockel (15) und der Rollenanordnung (13) angeordnet ist.

2. Handlauftemperier-Vorrichtung (11) nach Anspruch 1, wobei die Rollenanordnung (13) einen Rollenrahmen (27) und eine Vielzahl von Rollen (21) umfasst, die nebeneinander und bezüglich ihrer Drehachsen parallel zueinander angeordnet, im Rollenrahmen (27) drehbar gelagert sind.

3. Handlauftemperier-Vorrichtung (11) nach Anspruch 2, wobei der Rollenrahmen (27) die Rollen (21) nur seitlich umrahmt und wobei Zylinderflächen (23) der Rollen (21) zumindest eine Seitenfläche (25) des Rollenrahmens (27) überragen.

4. Handlauftemperier-Vorrichtung (11) nach einem der vorhergehenden Ansprüche, wobei der Sockel (15) aus einem wärmeleitenden Material gefertigt ist und ein Stützteil (41) und eine Wärmeableitungsstruktur (49) aufweist, welche Wärmeableitungsstruktur (49) auf einer dem Rollenrahmen (27) abgewandten Seite des Stützteils (41) angeordnet ist.

5. Handlauftemperier-Vorrichtung (11) nach Anspruch 4, wobei das Stützteil (41) eine Stützfläche (38) und mindestens einen Vorsprung (37) aufweist, wobei der Vorsprung (37) in Seitenbereichen (47) des Stützteils (41) auf der Stützfläche (38) angeordnet ist und in einer der Wärmeableitungsstruktur (49) abgewandten Richtung von der Stützfläche (38) aufragt und die Aussparung (39) zumindest teilweise begrenzt.

6. Handlauftemperier-Vorrichtung (11) nach Anspruch 5, wobei mindestens zwei Halbleiterkühlelemente (19) in der Aussparung (39) angeordnet sind.

7. Handlauftemperier-Vorrichtung (11) nach einem der vorhergehenden Ansprüche 5 und 6, wenn sie von einem der Ansprüche 2 oder 3 abhängen, wobei das Halbleiterkühlelement (19) eine plattenartige Struktur aufweist und der Rollenrahmen (27), die Durchmesser der Rollen (21) und der mindestens eine Vorsprung (37) derart aufeinander abgestimmt sind, dass Zylinderflächen (23) der Rollen (21) einen minimalen Abstand von 0.0001mm bis 0.5mm, bevorzugt von 0.001mm bis 0.2mm, besonders bevorzugt von 0.01mm bis 0.1mm von einer Kühlfläche (43) des in der Aussparung (39) angeordneten Halbleiterkühlelementes (19) aufweisen.

8. Handlauftemperier-Vorrichtung (11) nach einem der Ansprüche 2, 3 und 5 bis 7, wenn sie von einem der Ansprüche 2 oder 3 abhängen, wobei die Rollen (21) aus Kupfer, aus einer Kupferlegierung, aus Aluminium oder einer Aluminiumlegierung gefertigt sind.

9. Handlauftemperier-Vorrichtung (11) nach Anspruch 8, wobei die Rollen (21) zumindest auf ihrer Zylinderfläche (23) eine schwarze Beschichtung aufweisen.

10. Fahrtreppe (1) oder Fahrsteig mit mindestens einer Balustrade (5) und mit einem an der Balustrade (5) umlaufend angeordneten Handlauf (3), **dadurch gekennzeichnet, dass** mindestens eine Handlauftemperier-Vorrichtung (11) nach einem der Ansprüche 1 bis 9 unter dem Handlauf (3) zum Temperieren von dessen Grifffläche (7) angeordnet ist, wobei die Grifffläche (7) über die Rollenanordnung (13) geführt wird und mit dieser in Berührungskontakt steht.

11. Fahrtreppe (1) oder Fahrsteig nach Anspruch 10, wobei entlang einer Bewegungsrichtung (F1) des umlaufenden Handlaufes (3) die mindestens eine Handlauftemperier-Vorrichtung (11) relativ zu einem Startpunkt (K) des den Handlauf (3) berührenden Fahrgastes stromaufwärts angeordnet ist.

12. Fahrtreppe (1) oder Fahrsteig nach einem der Anprüche 10 und 11, wobei für jeden vorhandenen Handlauf (3) wenigstens zwei Handlauftemperier-Vorrichtungen (11) vorgesehen sind und die wenigstens zwei Handlauftemperier-Vorrichtungen (11) in Abständen entlang der Bewegungsrichtung (F1) des Handlaufes (3) angeordnet sind.

13. Fahrtreppe (1) oder Fahrsteig nach einem der Ansprüche 10 bis 12, wobei die Handlauftemperier-Vorrichtung(en) (11) ferner eine Stromversorgung (67) umfasst/umfassen, welche dazu vorgesehen ist, dem Halbleiterkühlelement (19) Strom zuzuführen und ferner ein Temperaturregelungsmodul (61) umfasst, um die dem Halbleiterkühlelement (19) zuzuführende Ausgangsleistung der Stromversorgung (67) zu regeln.

14. Fahrtreppe (1) oder Fahrsteig nach Anspruch 13, wobei das Temperaturregelungsmodul (61) einen Handlauf-Temperaturmesssensor (63) und einen Prozessor (69) umfasst, wobei der Handlauf-Temperaturmesssensor (63) zum Messen der Temperatur des Handlaufs (3) verwendet wird und der Prozessor (69) vom Handlauf-Temperaturmesssensor (63) an ihn übertragene Messsignale verarbeiten kann und der Prozessor (69) dazu konfiguriert ist, die an das Halbleiterkühlelement (19) übertragene Ausgangsleistung der Stromversorgung (67) in Abhängigkeit von der vom Handlauf-Temperaturmesssensor (63) gemessenen Temperatur des Handlaufs (3) zu regeln.

15. Fahrtreppe (1) oder Fahrsteig nach Anspruch 14, wobei das Temperaturregelungsmodul (61) einen Umgebungs-Temperaturmesssensor (65) umfasst, wobei der Umgebungs-Temperaturmesssensor (65) zum Messen der Umgebungstemperatur der Fahrtreppe (1) oder des Fahrsteiges verwendet wird und der Prozessor (69) dazu konfiguriert ist, die an das Halbleiterkühlelement (19) übertragene Ausgangsleistung der Stromversorgung (67) in Abhängigkeit von einer vorgegebenen Differenz zur Aussentemperatur und unter Berücksichtigung der vom Handlauf-Temperaturmesssensor (63) gemessenen Temperatur des Handlaufs (3) zu regeln.

## Claims

1. A handrail temperature-control device (11) for a movably arranged handrail (3) of an escalator (1) or a moving walkway, wherein the handrail temperature-control device (11) comprises
• a base (15); and a semiconductor cooling element (19), **characterized in that**, the handrail temperature-control device (11) further comprises
• a roller arrangement (13) which is arranged on the base (15); and that the semiconductor cooling element (19) is arranged in a recess (39) between the base (15) and the roller arrangement (13).

2. The handrail temperature-control device (11) according to claim 1, wherein the roller arrangement (13) has a roller frame (27) and a plurality of rollers (21) which are arranged side by side and parallel to one another with respect to their axes of rotation and are rotatably mounted in the roller frame (27).

3. The handrail temperature-control device (11) according to claim 2, wherein the roller frame (27) frames the rollers (21) only laterally, and wherein cylindrical surfaces (23) of the rollers (21) protrude beyond at least one side surface (25) of the roller frame (27).

4. The handrail temperature-control device (11) according to any of the preceding claims, wherein the base (15) is made of a thermally conductive material and has a support member (41) and a heat dissipation structure (49), which heat dissipation structure (49) is arranged on a side of the support member (41) facing away from the roller frame (27).

5. The handrail temperature-control device (11) according to claim 4, wherein the support member (41) has a support surface (38) and at least one projection (37), the projection (37) being arranged in side regions (47) of the support member (41) on the support surface (38) and protruding from the support surface (38) in a direction facing away from the heat dissipation structure (49) and at least partially delimiting the recess (39).

6. The handrail temperature-control device (11) according to claim 5, wherein at least two semiconductor cooling elements (19) are arranged in the recess (39).

7. The handrail temperature-control device (11) according to any of the preceding claim 5 and 6, if they are depend on any of the claims 2 or 3, wherein the semiconductor cooling element (19) has a plate-like structure, and the roller frame (27), the diameters of the rollers (21), and the at least one projection (37) are coordinated with one another in such a way that cylindrical surfaces (23) of the rollers (21) have a minimum distance of 0.0001 mm to 0.5 mm, preferably 0.001 mm to 0.2 mm, particularly preferably 0.01 mm to 0.1 mm, from a cooling surface (43) of the semiconductor cooling element (19) arranged in the recess (39).

8. The handrail temperature-control device (11) according to any of the claims 2, 3 and 5 to 7, wherein the rollers (21) are made of copper, a copper alloy, aluminum, or an aluminum alloy.

9. The handrail temperature-control device (11) according to claim 8, wherein the rollers (21) have a black coating at least on their cylindrical surface (23).

10. An escalator (1) or moving walkway having at least one balustrade (5) and having a handrail (3) arranged circulating around the balustrade (5), **characterized in that** at least one handrail temperature-control device (11) according to any of the claims 1 to 9 is arranged under the handrail (3) for controlling the temperature of its grip surface (7), the grip surface (7) being guided over the roller arrangement (13) and being in contact therewith.

11. The escalator (1) or moving walkway according to claim 10, wherein the at least one handrail temperature-control device (11) is arranged upstream relative to a starting point (K) of the passenger touching the handrail (3) along a direction of movement (F1) of the circulating handrail (3).

12. The escalator (1) or moving walkway according to any of the claims 10 or 11, wherein at least two handrail temperature-control devices (11) are provided for each existing handrail (3), and the at least two handrail temperature-control devices (11) are arranged at intervals along the direction of movement (F1) of the handrail (3).

13. The escalator (1) or moving walkway according to any of the claims 10 to 12, wherein the handrail temperature-control device(s) (11) further comprise/comprises a current supply (67), which is provided to supply current to the semiconductor cooling element (19), and further comprises a temperature-regulating module (61) in order to regulate the output power of the current supply (67) to be supplied to the semiconductor cooling element (19).

14. The escalator (1) or moving walkway according to claim 13, wherein the temperature-regulating module (61) comprises a handrail temperature measurement sensor (63) and a processor (69), the handrail temperature measurement sensor (63) being used to measure the temperature of the handrail (3) and the processor (69) being capable of processing measurement signals transmitted to it from the handrail temperature measurement sensor (63), and the processor (69) being configured to regulate the output power of the current supply (67) transmitted to the semiconductor cooling element (19) as a function of the temperature of the handrail (3) measured by the handrail temperature measurement sensor (63).

15. The escalator (1) or moving walkway according to claim 14, wherein the temperature-regulating module (61) has an ambient temperature measurement sensor (65), the ambient temperature measurement sensor (65) being used to measure the ambient temperature of the escalator (1) or the moving walkway, and the processor (69) being configured to regulate the output power of the current supply (67) transmitted to the semiconductor cooling element (19) as a function of a predetermined difference from the outside temperature and taking into account the temperature of the handrail (3) measured by the handrail temperature measurement sensor (63).

## Revendications

1. Dispositif de régulation de la température d'une main courante (11) pour une main courante (3) disposée de manière mobile sur un escalier roulant (1) ou un trottoir roulant, le dispositif de régulation de la température d'une main courante (11) comprenant
• un socle (15) ; et un élément de refroidissement à semi-conducteur (19), **caractérisé en ce que** le dispositif de régulation de la température de la main courante (11) comprend en outre
• un agencement de rouleaux qui est disposé sur le socle (15) ; et **en ce que** l'élément de refroidissement à semi-conducteur (19) est disposé dans un évidement (39) entre le socle (15) et l'agencement de rouleaux (13).

2. Dispositif de régulation de la température des mains courantes (11) selon la revendication 1, dans lequel le dispositif à rouleaux (13) comprend un cadre à rouleaux (27) et une pluralité de rouleaux (21) qui sont disposés les uns à côté des autres et parallèlement les uns aux autres par rapport à leurs axes de rotation, et qui sont montés de manière rotative dans le cadre à rouleaux (27).

3. Dispositif de régulation de la température des mains courantes (11) selon la revendication 2, dans lequel le cadre à rouleaux (27) n'entoure les rouleaux (21) que latéralement et dans lequel les surfaces cylindriques (23) des rouleaux (21) dépassent au moins une surface latérale (25) du cadre à rouleaux (27).

4. Dispositif de régulation de la température des mains courantes (11) selon l'une des revendications précédentes, le socle (15) étant fabriqué dans un matériau thermoconducteur et comportant une partie d'appui (41) et une structure de dissipation thermique (49), laquelle structure de dissipation thermique (49) est disposée sur un côté de la partie d'appui (41) opposé au cadre à rouleaux (27).

5. Dispositif de régulation de la température d'une main courante (11) selon la revendication 4, dans lequel l'élément de support (41) comporte une surface d'appui (38) et au moins une saillie (37), la saillie (37) étant disposée dans des zones latérales (47) de l'élément de support (41) sur la surface d'appui (38) et s'élève dans une direction opposée à la structure de dissipation de chaleur (49) à partir de la surface d'appui (38) et délimite au moins partiellement l'évidement (39).

6. Dispositif de régulation de la température des mains courantes (11) selon la revendication 5, dans lequel au moins deux éléments de refroidissement à semi-conducteurs (19) sont disposés dans l'évidement (39).

7. Dispositif de régulation de la température des mains courantes (11) selon l'une des revendications précédentes 5 ou 6, lorsqu'elles dépendent de l'une des revendications 2 ou 3, l'élément de refroidissement à semi-conducteur (19) présentant une structure en forme de plaque et le cadre à rouleaux (27), les diamètres des rouleaux (21) et de la au moins une saillie (37) étant adaptés les uns aux autres de telle sorte que les surfaces cylindriques (23) des rouleaux (21) présentent une distance minimale de 0,0001 mm à 0,5 mm, de préférence de 0,001 mm à 0,2 mm, de préférence de 0,01 mm à 0,1 mm, par rapport à une surface de refroidissement (43) de l'élément de refroidissement à semi-conducteur (19) disposé dans l'évidement (39).

8. Dispositif de régulation de la température des mains courantes (11) selon l'une des revendications 2, 3 et 5 à 7, si elles dépendent de l'une des revendications 2 ou 3, les rouleaux (21) étant fabriqués en cuivre, en un alliage de cuivre, en aluminium ou en un alliage d'aluminium.

9. Dispositif de régulation de température pour main courante (11) selon la revendication 8, les rouleaux (21) présentant au moins sur leur surface cylindrique (23) un revêtement noir.

10. Escalier roulant (1) ou trottoir roulant avec au moins une balustrade (5) et une main courante (3) disposée tout autour de la balustrade (5), **caractérisé en ce qu'** qu'au moins un dispositif de régulation de la température de la main courante (11) selon l'une des revendications 1 à 9 est disposé sous la main courante (3) pour réguler la température de sa surface de préhension (7), la surface de préhension (7) étant guidée par le dispositif à rouleaux (13) et étant en contact avec celui-ci.

11. Escalier roulant (1) ou trottoir roulant selon la revendication 10, dans lequel, le long d'une direction de déplacement (F1) de la main courante circulaire (3), le au moins un dispositif de régulation de température de main courante (11) est disposé en amont par rapport à un point de départ (K) du passager en contact avec la main courante (3).

12. Escalier roulant (1) ou trottoir roulant selon l'une des revendications 10 ou 11, dans lequel au moins deux dispositifs de régulation de la température des mains courantes (11) sont prévus pour chaque main courante (3) existante et les au moins deux dispositifs de régulation de la température des mains courantes (11) sont disposés à intervalles réguliers le long de la direction de déplacement (F1) de la main courante (3).

13. Escalier roulant (1) ou trottoir roulant selon l'une des revendications 10 à 12, le dispositif de régulation de la température de la main courante(11) comprenant en outre une alimentation électrique (67) qui est prévue pour alimenter en courant l'élément de refroidissement à semi-conducteur (19) et comprenant en outre un module de régulation de température (61) pour réguler la puissance de sortie de l'alimentation électrique (67) à fournir à l'élément de refroidissement à semi-conducteur (19) de l'alimentation électrique (67).

14. Escalier roulant (1) ou trottoir roulant selon la revendication 13, le module de régulation de température (61) comprenant un capteur de mesure de température de main courante (63) et un processeur (69), le capteur de mesure de température de main courante (63) étant utilisé pour mesurer la température de la main courante (3) et le processeur (69) pouvant traiter les signaux de mesure transmis par le capteur de mesure de température de main courante (63) et le processeur (69) étant configuré pour réguler la puissance de sortie de l'alimentation électrique (67) transmise à l'élément de refroidissement à semi-conducteurs (19) en fonction de la température de la main courante (3) mesurée par le capteur de mesure de la température de la main courante (63).

15. Escalier roulant (1) ou trottoir roulant selon la revendication 14, le module de régulation de température (61) comprenant un capteur de mesure de la température ambiante (65), le capteur de mesure de la température ambiante (65) étant utilisé pour mesurer la température ambiante de l'escalier roulant (1) ou du trottoir roulant, et le processeur (69) étant configuré pour réguler la puissance de sortie de l'alimentation électrique (67) transmise à l'élément de refroidissement à semi-conducteurs (19) en fonction d'une différence prédéfinie par rapport à la température extérieure et en tenant compte de la température de la main courante mesurée par le capteur de température de main courante (63) (3)
